# EUROPEAN PATENT SPECIFICATION

(11) **EP 2 875 531 B1**
(45) Date of publication and mention of the grant of the patent: **06.05.2020**
(21) Application number: 13742357.0
(22) Date of filing: 17.07.2013
(51) Int. Cl.: H01L 31/048

(54) **METHOD PROVIDING AN EXTRUDED EDGE SEAL ON A PHOTOVOLTAIC MODULE**
VERFAHREN ZUR HERSTELLUNG EINES PHOTOVOLTIK-MODULS MIT AUSGEPRESSTER KANTENDICHTUNG
PROCÉDÉ FOURNISSANT UN JOINT D'ÉTANCHÉITÉ DE BORD EXTRUDÉ SUR UN MODULE PHOTOVOLTAÏQUE

(30) Priority: 17.07.2012 US 201261672545 P; 02.08.2012 US 201261678848 P
(43) Date of publication of application: 27.05.2015
(73) Proprietor: First Solar, Inc, Perrysburg, OH 43551 (US)
(72) Inventor: BAKER, Christopher, Maumee, OH 43537 (US); KOTARBA, Casimir, Perrysburg, OH 43551 (US); KRAWCZYK, Karina, Durham, NC 27703 (US); NAWROCKI, Paul, Rossford, OH 43460 (US); ST. JOHN, Nicholas, Toledo, OH 43613 (US)
(74) Representative: Thurston, Joanna
(86) International application number: PCT/US2013/050784
(87) International publication number: WO 2014/014972

(56) References cited:
- EP-A2- 2 256 826
- WO-A1-2009/097062
- WO-A2-2008/106565
- WO-A2-2009/029897
- US-A1- 2009 320 921
- US-A1- 2012 055 550

## Description

### FIELD OF THE INVENTION

The disclosed embodiments relate generally to a photovoltaic module, which may include modules containing one or more photovoltaic cells or any device that converts light to electricity, and more particularly, to a photovoltaic module with an extruded edge seal, and the invention in particular, relates to a method for manufacturing the same.

### BACKGROUND

A photovoltaic module may include various internal components for producing electricity from light. For example, a photovoltaic module can include a front cover and a back cover. The front and back covers may be made of many different types of material, but are typically glass. A plurality of material layers, such as semiconductor materials and conductor materials, can be disposed between the front cover and the back cover. The semiconductor
layers are often provided between conductor layers and generally include n-type and p-type semiconductor materials. The n-type and p-type semiconductor materials are disposed in close proximity to each other to form a p-njunction where light is converted to electricity. Using the conductor layers, the electricity may be provided to external devices. Hence, the semiconductor and conductor layers may collectively be referred to as an "active layer" of the photovoltaic module. The back cover together with the front cover form the outer surfaces of the module.

The internal structure of the modules, including the active layer, needs to be kept sealed from the surrounding external environment to prevent degradation of the layers. Further, they also need to be insulated to minimize any risk of electric shock from electricity generated by the module to those installing or servicing the module. As mentioned above, the back cover and front cover are often made of glass. As such, they serve in large measure to seal and insulate the module's interior from the external environment. However, the module edges are not covered by the front and back cover and thus are exposed to the external environment.

Presently, to seal and insulate the edges of a module, a portion of the active layer near the edge is removed through a process called "edge delete" to space the active layer away from the module's edges. After doing so, an insulating material is placed in the space that has been deleted to fill in the area. Depending on the insulating material, it may also be used to seal the edges of the module from the external environment. However, this process yields a photovoltaic module with less than optimal efficiency because the active area that has been deleted is not present to convert light to electricity. Also, additional manufacturing steps are required to make photovoltaic modules with edges that are insulated and sealed in this manner.

Consequently, an easier and more robust method and apparatus for providing an edge seal that may also be used to insulate the edge of a photovoltaic module is desired.

US 20121055550 discloses a solar module with a front support, a back support, and a photovoltaic active material located between the front and back supports. An electrically insulative light transmissive seal is located at the peripheral edges of the front support and back support to electrically isolate the active material from the outer surfaces of the solar module.

WO 2009/097062 discloses a photovoltaic assembly including first and second substrates joined together and spaced apart, on either side of an airspace, by a seal system formed of a first seal and a second seal, the second seal comprising one or more silyl terminated polyacrylate polymers.

WO 2009/029897 discloses a photovoltaic module comprising a plurality of photovoltaic cells positioned between a transparent module layer and a backside module layer.

WO 2008/106656 discloses a method of processing multimedia data which may include encoding a frame of the multimedia data as an I frame, a channel switch frame, and a P frame and selecting the encoded I frame if a size of the encoded I frame and a size of the encoded channel switch frame and the encoded P frame meet a first condition.

### DESCRIPTION OF THE DRAWINGS

FIG. 1A is a diagram of an extruding device adjacent to a photovoltaic module;
FIG. 1B is a diagram of an extruding device adjacent to a photovoltaic module;
FIG. 1C is a another diagram of an extruding device adjacent to a photovoltaic module;
FIG 1D is a still another diagram of an extruding device adjacent to a photovoltaic module;
FIG. IE is a diagram of an exemplary extruder head;
FIG. IF is a diagram of another exemplary extruder head;
FIG. 2 is a diagram of a photovoltaic module with and extruding device in use;
FIG. 3 is a diagram of a photovoltaic module with an extruded edge seal;
FIG. 4A is a diagram of a photovoltaic module with an extruded edge seal;
FIG. 4B is a diagram of a photovoltaic module with an extruded edge seal; and
FIG 5 is a flowchart showing a method of forming an extruded edge seal on a photovoltaic module.

### DETAILED DESCRIPTION

An invention is provided as defmed in the appended claims. An edge seal can be extruded onto at least a portion of an edge of a photovoltaic module to seal and insulate the edge of the module. Extruding involves forming or shaping a material, often one or more polymers, by pushing it out through an orifice or die. An edge seal that is formed by extruding is known as an extruded edge seal, and has different physical properties from edge seals that are formed by other methods, such as spraying.

An extruded edge seal may include one or more polymeric materials. Applying the one or more polymeric materials by extrusion forms an edge seal on the top, bottom, and side edge of the photovoltaic module simultaneously. In some embodiments, the extruded edge seal may further comprise a bonding layer to ensure good adhesion of the extruded edge seal to the photovoltaic module. The bonding layer has acceptable adhesion to the front and back covers, to the side edge of the module, and to an overlying second layer of extruded material. The extruded edge seal can decrease the edge delete area because the bulk of the extruded layer can allow the active layer to extend closer to the module edges. The extruded edge seal can be simple to apply in a manufacturing setting.

Reference is now made to the Figures, wherein like reference numbers are used throughout to refer to like elements.

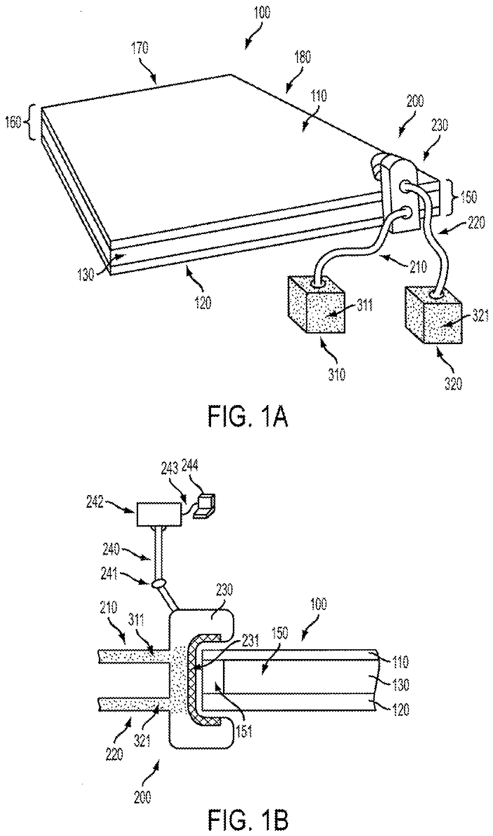

Referring first to Figure 1A, a photovoltaic module 100 includes a front glass 110, an active layer 130 and a back glass 120. The photovoltaic module 100 features a first side edge 150, which extends along an edge of the module between two corners, a second side edge 160, a third side edge 170, and a fourth side edge 180. In this particular embodiment, the active layer 130 extends all the way to the side edges 150, 160, 170, and 180. As such, there is no edge delete area in Figure 1A. The absence of an edge delete area means that more active layer is available for the conversion of light to electricity than in photovoltaic modules that have an edge delete area.

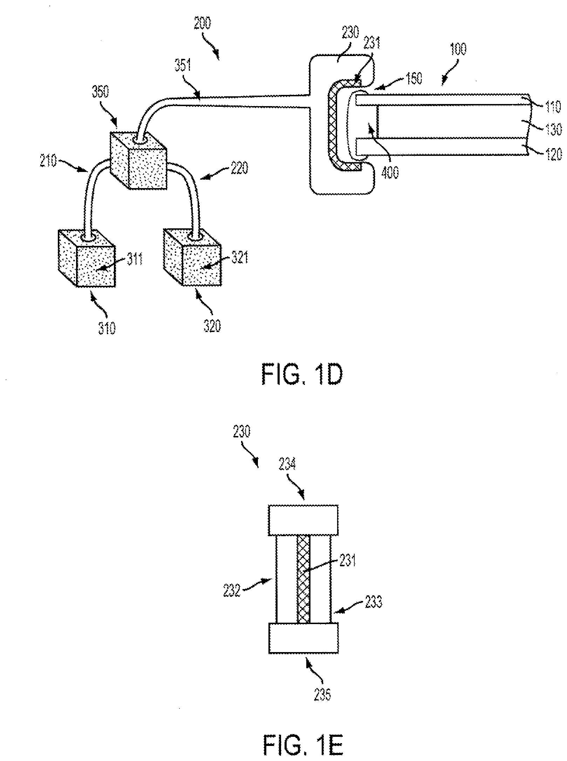

Adjacent to the photovoltaic module 100 is an extruding device 200. The extruding device 200 can be used to extrude polymers that may be used to seal and insulate the edges of the photovoltaic module 100. In this particular example, two polymers are used. To extrude the two polymers, a first material conduit 210 and a second material conduit 220 connected to extruder head 230 are used. The extruder head 230 is located adjacent to an edge, e.g., the first side edge 150, of the photovoltaic module 100. The first material conduit 210 is connected to a first container 310, and the second material conduit 220 is connected to a second container 320. The first container 310 holds a first polymer 311, which may be a liquid polymer (a liquid polymer is a polymer that is a liquid under extrusion conditions, such as a polymer that is melted under extrusion conditions), or a polymer solution (a polymer solution is a polymer that is dissolved in a solvent). The second container 320 holds a second polymer 321. Just as in the case of the first polymer, the second polymer may be a liquid polymer or a polymer solution. If the first polymer 311 and the second polymer 321 are extruded simultaneously, then they can be mixed inside the extruder head 230. Alternatively, as shown in Figure 1D, a mixing chamber 350 may be provided between the containers 310 and 320, and the extruder head 230 to mix the first polymer with the second polymer. Otherwise a selection mechanism, such as one or more valves, can also be provided in the polymer flow path so that only one of the polymers is extruded at a time.

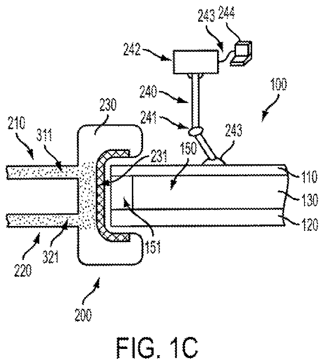

Figures 1B, 1C, and 1D are alternatives to the embodiment shown in Figure 1A. Figure 1B shows photovoltaic module 100 and extruding device 200. The extruder head 230 is generally C-shaped, so that an extrusion opening 231 of the extruder head 230 can be in a close proximity to the front glass 110, the back glass 120, and the active layer 130 near the first side edge 150 of the photovoltaic module 100. Unlike the embodiment shown in Figure 1A, Figure 1B depicts an active layer 130 that is recessed from the front glass 110 and back glass 120 at the first side edge 150, leaving a space between the front glass 110 and the back glass 120. This provides a distance known as "tracking distance," from the active layer to the edge of the module. Tracking distances help prevent electrical leakage from the module, and are used to further separate the active layer 130 from the external environment. Filler 151, which may be a sealant material provided during manufacture of photovoltaic module 100, partially or completely fills the space between the front glass 110 and the back glass 120 along the perimeter of the photovoltaic module 100.

In use, the first polymer 311 and/or the second polymer 321 flow through opening 231 and are extruded onto the top of the front glass 110, the bottom of back glass 120, and the first side edge 150 simultaneously. The extruder head 230 is attached to an arm 240, which comprises a joint 241, and is attached to a moving module 242 which moves the arm 240 and the attached extruder head 230 to a desired position adjacent to an edge, such as the first side edge 150, of the photovoltaic module 100. The moving module 242 is in communication with a control unit 244 by way of a communication link 243, such as a wire or wireless link, that allows communication between the control unit 244 and the arm 240. The control unit 244 can be used to control the moving module 242 and the arm 240, including the joint 241, thereby moving extruder head 230 to a desired location or in a desired path. For example, the extruder head 230 can travel along at least a portion of an edge, such as the first side edge 150, of the photovoltaic module 100. In the same manner, the extruder head 230 can travel around the entire perimeter of the photovoltaic module 100. The control unit 244 is shown as being external to the extruding device 200, however, it may instead be integrated into the extruding device 200.

Figure 1C is a cross-sectional profile view of a photovoltaic module 100 and extruding device 200. In Figure 1C, the extruding device 200 has a fixed extruder head 230. The arm 240 and moving module 242 are connected to the photovoltaic device 100 by suction cup 243 to move the edges of the photovoltaic device 100 through the fixed extruder head 230 to extrude an edge seal by rotating the photovoltaic module 100 during extrusion. The edge seal can be extruded on one or more side edges of the photovoltaic module 100.

Figure 1D is another cross sectional side profile view of photovoltaic module 100 and extruding device 200. The first polymer 311 and second polymer 321 are drawn out of the first container 310 and second container 320, respectively, and through the first material conduit 210 and second material conduit 220 into a mixing chamber 350. The first polymer 311 and second polymer 321 are mixed in the mixing chamber 330 and the mixture of the first polymer 311 and second polymer 321 is transported through a mixed-material conduit 351 to the extruder head 230.

Figure 1E shows a front view of the extruder head 230, which includes a top 234, a bottom 235, a first side 232, and a second side 233. The extruder head 230 also includes an extrusion opening 231, which allows extruded materials to pass through the extruder head 230 and onto a side edge of a photovoltaic module 100. Extruder head 230 can be a fixed die or a variable die. If extruder head 230 is a fixed die, then the aperture of extrusion opening 231 does not vary. If extruder head 230 is a variable die, then the aperture of extrusion opening 231 can vary, for example to control the flow of extruded materials through the extrusion opening 231.

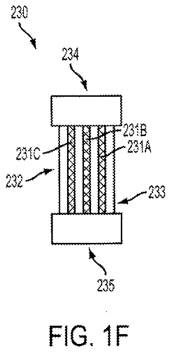

Figure 1F shows a front view of a different configuration of the extruder head 230. Here, the extruder head 230 has multiple extrusion openings 231A, 231B, and 231C, each of which can be connected to a separate polymer container. As in Figure 1E, extruder head 230 can be a fixed die or a variable die. If extruder head 230 is a fixed die, then the aperture of extrusion openings 231A-C do not vary. If extruder head 230 is a variable die, then the aperture of extrusion openings 231A-C can vary. This configuration may be useful, for example, in embodiments where the extruded edge seal contains more than one polymer layer. Exemplary embodiments with multiple polymer layers are discussed below.

Although FIGS. 1A-F show particular configurations of extruding device 200 and extruder head 230, extrusion may be accomplished by using any extruding device 200 known in the art. In some embodiments, such as when only a first polymer 311 is used, the extrusion device may only need first material conduit 210, and only one source of polymer material. In other embodiments, more than two material conduits and more than two containers, each holding one or more polymers, may be used.

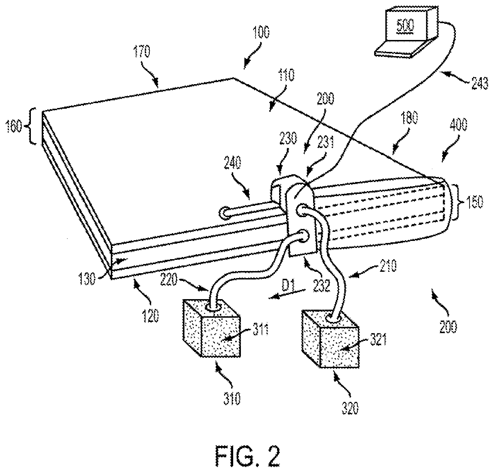

Figure 2 shows the extruding device 200, which includes a sensing mechanism 240 that is operable during an extruding operation. The sensing mechanism 240 is configured to sense variations in the thickness and/or shape of photovoltaic module 100 at or near an edge, for example, the side edge 150. A communication link 243 reports these variations to a control module 500, which may, in response, alter one or more of the speed, direction, and path travelled by the extruder head 230, and/or the rate of polymer extrusion. For example, if a first polymer 311 and/or second polymer 321 is extruded, the control module can alter one or more of the speed, direction, path, and rate of extrusion of the first polymer 311 and/or second polymer 322, in order to ensure uniform and defect-free application of the first polymer 311 and/or second polymer 321. The rate of polymer extrusion can be altered, for example, by varying the flow rate of the first polymer 311 and/or the second polymer 321 through a first material conduit 210 or a second material conduit 220 with the control module 500. If the extruder head 230 is a variable die, then the rate of polymer extrusion can also be altered by varying the aperture of the extrusion opening 231 with the control module 500. A variable die can be particularly useful in applying a first polymer 311 and/or second polymer 321 to a photovoltaic module 100 with an inconsistent thickness. In Figure 2, the control module 500 is shown as being external to the extruding device 200, however, it may instead be integrated into the extruding device 200, although this is not required. The control module 500 may also be integrated with the control unit 244 (Figure 1), although this is also not required.

As extruder head 230 travels in direction D1 along the first side edge 150 of photovoltaic module 100, first polymer 311 and/or second polymer 321 is drawn out of first container 310 and/or second container 320 through first material conduit 210 and/or second material conduit 220. The first polymer 311 and/or the second polymer 321 are then extruded by the extruder head 230 directly onto the first side edge 150 of the photovoltaic module 100, thereby forming an extruded edge seal 400 over the first side edge 150.

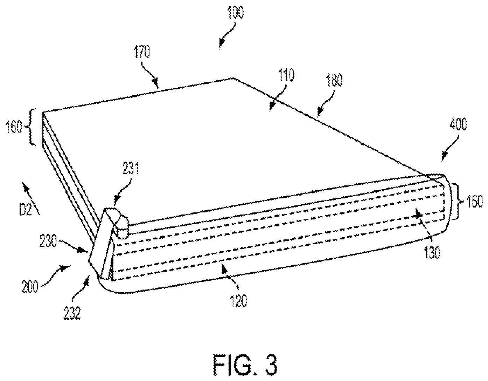

Figure 3 shows the extruded edge seal 400 applied to the entire first side edge 150, including portions of the front glass 110 and the back glass 120 near first side edge 150. The extruder head 230 is now adjacent to the second side edge 160, and is travelling in direction D2 in order to apply the extruded edge seal 400 on the second side edge 160.

The one or more polymers used to form the extruded edge seal 400 can include any polymers known in the art that are suitable for extrusion. The polymers can be extruded as liquid polymers, or as polymer solutions that are suitable for extrusion. For example, the polymers can include, but are not limited to, silicone, poly(ethylene-co-methacrylic acid) such as Surlyn® (a registered trademark of E.L du Pont de Nemours and Company), poly(ethylene vinylacetate) (EVA), ionomers, thermoplastic polyolefins (TPO), thermoplastic polyurethanes (TPU), poly(vinylbutylene) (PVB), poly(vinylydine chloride) (PVDF), poly(ethylene-co-tetrafluoroethalene) (ETFE), fluorinated ethylene propylene polymer (FEP), poly(ethylene chlorotetrafluoroethylene) (ECTFE), polyethylene terphthalate) (PET), poly(vinyl fluoride) (PVF), polyvinyl chloride) (PVC), and polycarbonate) (PC), copolymers thereof, and mixtures of any of the foregoing polymers and copolymers.

In some embodiments, the extruded edge seal 400 may contain only one first polymer 311. In other embodiments, the extruded edge seal 400 may contain a blend of more than one polymers.

In further embodiments, extruded edge seal 400 can include more than one polymer layer. In such embodiments, a first polymer can be extruded directly onto photovoltaic module 100, and a second polymer can then be extruded onto the first polymer to form a multi-layered extruded edge seal 400. The second polymer can be the same as or different from the first polymer. In still other embodiments, additional polymer layers can be extruded over the second polymer layer to form a multi-layered extruded edge seal 400.

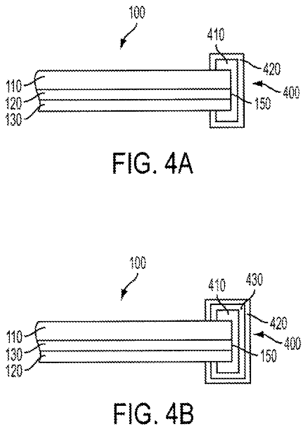

Figures 4A and 4B depict embodiments where edge seal 400 includes multiple polymer layers. In Figure 4A, extruded edge seal 400 has been applied to first side edge 150. Extruded edge seal 400 includes first layer 410 and second layer 420. The first layer 410 may be, for example, a bonding layer that facilitates adhesion of a second layer 420 to the module 100, and may include, for example, silicone, poly(ethylene-co-methacrylic acid), EVA, copolymers thereof, or mixtures of any of the foregoing polymers and copolymers. The second layer 420 may be, for example, a dielectric layer for electrically insulating the active layer 130 from the module exterior, and may include, for example, PVDF, ETFE, FEP, ECTFE, PET, PVF, PC, copolymers thereof, or mixtures of any of the foregoing polymers and copolymers.

In Figure 4B, edge seal 400 further includes a third layer 430, which is disposed between first layer 410 and second layer 420. Third layer 430 may be, for example, a thermoplastic encapsulant layer for encapsulating module edge, including the active layer 130, and may include, for example, TPE, TPO, PTU, PVB, copolymers thereof, or mixtures of any of the foregoing polymers and copolymers. In addition or alternative to being a thermoplastic the third layer 430 can be, for example, at least one of an adhesive layer for adhering the first and second layers and a layer that provides additional barrier properties, such as moisture barrier properties.

The extrusion head 230 can travel around the entire perimeter of the photovoltaic module 100 in a continuous manner. Thus, the extruded edge seal 400 can be applied to all four edges, 150, 160, 170, and 180 of the photovoltaic module 100 in a continuous process without interruption. Furthermore, because the extruder head 230 may have multiple material conduits each connected to containers holding different polymers, an extruded edge seal 400 having multiple layers can be formed in a continuous process. In such a process, each layer can be formed in a separate pass of the extruder head 230 around the perimeter of the photovoltaic module 100. For example, a three-layer extruded edge seal 400, such as the one depicted in Figure 4B, can be formed using an extruder head 230 with three material conduits, each of the three material conduits connected to different containers holding, for example, three different polymers such as EVA, PVDF, and TPO. Particular configurations of extruder head 230, for example the configuration shown in Figure 1E, may be useful in this embodiment For example, if the extruder head 230 is used in the configuration shown in Figure 1F, then EVA can be extruded through first opening 231A in the extruder head 230 during a first pass of the extruder head 230 around the photovoltaic module 100, PVDF can be extruded through second opening 231B during a second pass, and TPO can be extruded through third opening 231C during a third pass.

In other embodiments, the same result can be achieved with only a single material conduit. For example, a two-layer edge seal, such as the one depicted in Figure 4A, can be formed using the extruder head 230 with only a first material conduit 210. The first material conduit 210 can be connected to a first container 310 containing, for example, EVA. The EVA can be extruded during a first pass of the extruder head 230 around the perimeter of the photovoltaic module 100. The first material conduit 210 can then be switched from the first container 310 to the second container 320, which can contain, for example, PVDF. The PVDF can be extruded during a second pass of the extruder head 230 around the perimeter of the photovoltaic module 100. A three-layer edge seal, such as the one depicted in Figure 4B, can be formed by a similar method by switching from the second material container 320 to a third container that contains a third polymer. Switching can be accomplished by a switching mechanism including valves in one or more of the first material conduit 210, second material conduit 220, and extruder head 230.

In some embodiments, an edge seal 400 with more than one layer can be manufactured using more than one extruder head. For example, the first layer 410 can be formed on the photovoltaic module 100 using a first extruder head, which can extrude one or more components, such as one or more polymers, of the first layer 410 during a pass around a perimeter of the photovoltaic module 100. The third layer 430 can also be formed on top of the first layer 410 using a second extruder head, which can extrude one or more components, such as one or more polymers, of the third layer 430 during a pass around a perimeter of the photovoltaic module 100. The second layer 420 can be formed on top of the third layer 430 using a second extruder head, which can extrude one or more components, such as one or more polymers, of the second layer 420 during a pass around a perimeter of the photovoltaic module 100.

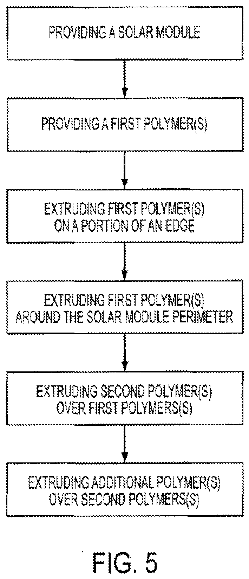

Figure 5 is a flowchart delineating exemplary steps of a process that may be used to apply an extruded layer 400 around the edges of a photovoltaic module 100. The exemplary steps include providing the photovoltaic module 100 around the edges of which an insulated seal is to be provided. The insulated seal may include one or more polymers. An insulating seal that is suitable for extrusion can be provided. The insulating seal can be extruded. In the case, where the insulated seal is made up of one polymer, the polymer can be extruded around the edges of the module using one pass. In the case where the insulated seal is made up of more than one polymer, each polymer can be extruded around the edge of the module in each successive pass. Thus, there can be as many passes as there are polymers to be extruded.

Importantly, not all of the steps shown in Figure 5 are required. For example, in some applications one or more side edges or one or more portions of side edges can be sealed by an extruded edge seal, and the remaining side edges or portions of side edges can be sealed by another means. In this case, steps involving extruding polymer(s) around the entire module perimeter can be omitted. If a single layer extruded edge seal 400 is required, then the steps of extruding a second polymer(s) over the first polymer(s) and extruding additional polymer(s) over the second polymers) can be omitted. If a two layer extruded edge seal 400 is required, then step of extruding additional polymer(s) over the second polymer(s) can be omitted.

A number of embodiments of the invention have been described. Nevertheless, it will be understood that various modifications may be made. For example, while the invention has been described in relationship to a photovoltaic module having four edges, it can be applied to photovoltaic modules of any shape, including triangular, circular, hexagonal, etc. Furthermore, while the invention has been described in relationship to particular extruding devices, it should be understood that any device capable of applying an edge seal could be used. It should also be understood that the appended drawings are not necessarily to scale.

## Claims

1. A method of making a photovoltaic module (100) with an edge seal (400), the photovoltaic module (100)comprising a front cover (110), a back cover (120), and an active layer (130)disposed between the front and back covers (110, 120), the method being **characterised in that** it comprises: extruding one or more materials onto both the front cover (110) and the back cover (120) to form an edge seal on the top, bottom, and side edge of the photovoltaic module simultaneously, such that the active layer is sealed.

2. The method of claim 1, wherein:
at least a portion of the edge seal (400) is extruded from an extruding device (200) comprising an extruder head (230); and
wherein the step of extruding one or more materials comprises at least one of moving the extruder head (230) around at least a portion of a perimeter of the photovoltaic module (100) while extruding the edge seal (400), and moving at least a portion of a perimeter of the photovoltaic module (100) through the extruder head (230) while extruding the edge seal (400).

3. The method of claim 2, further comprising:
transmitting one or more signals indicating variations in at least one of thickness and shape of the photovoltaic module (100) to a control module (500) that controls at least one of the operation of the extruder head (230) and the movement of the photovoltaic module (100) through the extruder head (230),
wherein in response to the one or more signals transmitted by the sensing mechanism (240), the control module (500) causes a change in a rate of extrusion of one or more polymers from the extruding device (200).

4. The method of claim 2, wherein moving the extruder head (230) a comprises moving the extruder head (230) in a first pass around the perimeter of the photovoltaic module (100) while extruding a first layer of the one or more polymeric materials.

5. The method of claim 4 wherein moving the extruder head (230) further comprises moving the extruder head (230) around the perimeter of the photovoltaic module (100) in a second pass while extruding a second layer of the one or more polymers.

6. The method, of claim 5, wherein the step of moving the extruder head (230) further comprises moving the perimeter of the photovoltaic module (100) in a third pass while extruding a third layer of one or more polymers.

7. The method of claim 1, wherein the extruder head (230) is C-shaped.

8. The method of claim 2, wherein the step of extruding one or more polymeric materials further comprises:
extruding a first layer of the edge seal (400) with a first extruder head (230); and
extruding a second layer of the edge seal (400) with a second extruder head on the first layer of the edge seal (400); and
extruding a third layer of the edge seal (400) with a third extruder head.

9. The method of claim 1, wherein extruding the one or more materials comprises sealing an entire perimeter of the photovoltaic module (100).

10. The method (100) of claim 1, wherein the active layer (130) is recessed from the front contact (110) and the back contact (120) to leave a space between the front contact (110) and the back contact (120), and wherein the method further comprises completely filling with a filler (151) the space along a perimeter of the photovoltaic module (100).

## Patentansprüche

1. Verfahren zum Herstellen eines Photovoltaikmoduls (100) mit einer Kantendichtung (400), wobei das Photovoltaikmodul (100) eine vordere Abdeckung (110), eine hintere Abdeckung (120) und eine aktive Schicht (130), die zwischen der vorderen und hinteren Abdeckung (110, 120) angeordnet ist, umfasst, wobei das Verfahren **dadurch gekennzeichnet ist, dass** es Folgendes umfasst: Extrudieren eines oder mehrerer Materialien auf sowohl die vordere Abdeckung (110) als auch die hintere Abdeckung (120), um eine Kantendichtung an der oberen, unteren und seitlichen Kante des Photovoltaikmoduls gleichzeitig auszubilden, sodass die aktive Schicht abgedichtet ist.

2. Verfahren nach Anspruch 1, wobei:
mindestens ein Abschnitt der Kantendichtung (400) aus einer Extrudiervorrichtung (200), die einen Extruderkopf (230) umfasst, extrudiert wird; und
wobei der Schritt des Extrudierens eines oder mehrerer Materialien mindestens eines von Bewegen des Extruderkopfs (230) um mindestens einen Abschnitt eines Umfangs des Photovoltaikmoduls (100) während des Extrudierens der Kantendichtung (400) und Bewegen mindestens eines Abschnitts eines Umfangs des Photovoltaikmoduls (100) durch den Extruderkopf (230) während des Extrudierens der Kantendichtung (400) umfasst.

3. Verfahren nach Anspruch 2, ferner umfassend:
Übertragen eines oder mehrerer Signale, die Schwankungen mindestens eine von der Dicke und der Form des Photovoltaikmoduls (100) angeben, an ein Steuermodul (500), das mindestens eines von dem Betrieb des Extruderkopfs (230) und der Bewegung des Photovoltaikmoduls (100) durch den Extruderkopfs (230) steuert,
wobei das Steuermodul (500) als Reaktion auf das eine oder die mehreren Signale, die durch den Erfassungsmechanismus (240) übertragen werden, eine Veränderung einer Extrusionsgeschwindigkeit eines oder mehrerer Polymere aus der Extrudiervorrichtung (200) veranlasst.

4. Verfahren nach Anspruch 2, wobei das Bewegen des Extruderkopfs (230) ein Bewegen des Extruderkopfs (230) in einem ersten Durchgang um den Umfang des Photovoltaikmoduls (100) umfasst, während eine erste Schicht des einen oder der mehreren Polymermaterialien extrudiert wird.

5. Verfahren nach Anspruch 4, wobei das Bewegen des Extruderkopfs (230) ferner ein Bewegen des Extruderkopfs (230) um den Umfang des Photovoltaikmoduls (100) in einem zweiten Durchgang umfasst, während eine zweite Schicht des einen oder der mehreren Polymere extrudiert wird.

6. Verfahren nach Anspruch 5, wobei der Schritt des Bewegens des Extruderkopfs (230) ferner ein Bewegen des Perimeters Umfangs des Photovoltaikmoduls (100) in einem dritten Durchgang umfasst, während eine dritte Schicht eines oder mehrerer Polymere extrudiert wird.

7. Verfahren nach Anspruch 1, wobei der Extruderkopf (230) C-förmig ist.

8. Verfahren nach Anspruch 2, wobei der Schritt des Extrudierens eines oder mehrerer Polymermaterialien ferner umfasst:
Extrudieren einer ersten Schicht der Kantendichtung (400) mit einem ersten Extruderkopf (230); und
Extrudieren einer zweiten Schicht der Kantendichtung (400) mit einem zweiten Extruderkopf auf die erste Schicht der Kantendichtung (400); und
Extrudieren einer dritten Schicht der Kantendichtung (400) mit einem dritten Extruderkopf.

9. Verfahren nach Anspruch 1, wobei das Extrudieren des einen oder der mehreren Materialien Abdichten eines gesamten Umfangs des Photovoltaikmoduls (100) umfasst.

10. Verfahren (100) nach Anspruch 1, wobei die aktive Schicht (130) von dem vorderen Kontaktelement (110) und dem hinteren Kontaktelement (120) zurückgesetzt ist, um einen Raum zwischen dem vorderen Kontaktelement (110) und dem hinteren Kontaktelement (120) zu belassen, und wobei das Verfahren ferner vollständiges Füllen des Raums entlang eines Umfangs des Photovoltaikmoduls (100) mit einem Füllstoff (151) umfasst.

## Revendications

1. Procédé de fabrication d'un module photovoltaïque (100) avec un joint d'étanchéité de bord (400), le module photovoltaïque (100) comprenant un couvercle avant (110) et un couvercle arrière (120), et une couche active (130) disposée entre les couvercles avant et arrière (110, 120), le procédé étant **caractérisé en ce qu'**il comprend :
l'extrusion d'un ou de plusieurs matériaux à la fois sur le couvercle avant (110) et le couvercle arrière (120) pour former un joint d'étanchéité de bord sur le bord supérieur, inférieur et latéral du module photovoltaïque simultanément, de sorte que la couche active est scellée.

2. Procédé selon la revendication 1, dans lequel :
au moins une partie du joint d'étanchéité de bord (400) est extrudée à partir d'un dispositif d'extrusion (200) comprenant une tête d'extrudeuse (230) ; et
dans lequel l'étape d'extrusion d'un ou de plusieurs matériaux comprend au moins l'un du déplacement de la tête d'extrudeuse (230) autour d'au moins une partie d'un périmètre du module photovoltaïque (100) pendant l'extrusion du joint d'étanchéité de bord (400), et du déplacement d'au moins une partie d'un périmètre du module photovoltaïque (100) à travers la tête d'extrudeuse (230) pendant l'extrusion du joint d'étanchéité de bord (400).

3. Procédé selon la revendication 2, comprenant en outre :
la transmission d'un ou de plusieurs signaux indiquant des variations d'au moins l'une parmi l'épaisseur et la forme du module photovoltaïque (100) à un module de commande (500) qui commande au moins l'un du fonctionnement de la tête d'extrudeuse (230) et du déplacement du module photovoltaïque (100) à travers la tête d'extrudeuse (230),
dans lequel en réponse aux un ou plusieurs signaux transmis par le mécanisme de détection (240), le module de commande (500) entraîne un changement de vitesse d'extrusion d'un ou de plusieurs polymères à partir du dispositif d'extrusion (200).

4. Procédé selon la revendication 2, dans lequel le déplacement de la tête d'extrudeuse (230) comprend le déplacement de la tête d'extrudeuse (230) dans un premier passage autour du périmètre du module photovoltaïque (100) pendant l'extrusion d'une première couche des un ou plusieurs matériaux polymères.

5. Procédé selon la revendication 4, dans lequel le déplacement de la tête d'extrudeuse (230) comprend en outre le déplacement de la tête d'extrudeuse (230) autour du périmètre du module photovoltaïque (100) dans un deuxième passage pendant l'extrusion d'une deuxième couche des un ou plusieurs polymères.

6. Procédé selon la revendication 5, dans lequel l'étape de déplacement de la tête d'extrudeuse (230) comprend en outre le déplacement du périmètre du module photovoltaïque (100) dans un troisième passage pendant l'extrusion d'une troisième couche d'un ou de plusieurs polymères.

7. Procédé selon la revendication 1, dans lequel la tête d'extrudeuse (230) est en forme de C.

8. Procédé selon la revendication 2, dans lequel l'étape d'extrusion d'un ou de plusieurs matériaux polymères comprend en outre :
l'extrusion d'une première couche du joint d'étanchéité de bord (400) avec une première tête d'extrusion (230) ; et l'extrusion d'une deuxième couche du joint d'étanchéité de bord (400) avec une deuxième tête d'extrudeuse sur la première couche du joint d'étanchéité de bord (400) ; et
l'extrusion d'une troisième couche du joint d'étanchéité de bord (400) avec une troisième tête d'extrudeuse.

9. Procédé selon la revendication 1, dans lequel l'extrusion des un ou plusieurs matériaux comprend le scellement d'un périmètre entier du module photovoltaïque (100).

10. Procédé (100) selon la revendication 1, dans lequel la couche active (130) est en retrait par rapport au contact avant (110) et au contact arrière (120) pour laisser un espace entre le contact avant (110) et le contact arrière (120), et dans lequel le procédé comprend en outre le remplissage complet avec une charge (151) de l'espace le long d'un périmètre du module photovoltaïque (100).
